(19) Europäisches Patentamt
European Patent Office
Office européen des brevets

(11) **EP 3 486 744 B1**

(12) **EUROPEAN PATENT SPECIFICATION**

(45) Date of publication and mention
of the grant of the patent:
**04.03.2020 Bulletin 2020/10**

(51) Int Cl.:
*G06F 1/18* *(2006.01)*    *G06F 1/20* *(2006.01)*

(21) Application number: **18201182.5**

(22) Date of filing: **18.10.2018**

(54) **AERODYNAMIC NOISE ABSORBER MODULE**

AERODYNAMISCHES LUFTSCHALLABSORBERMODUL

MODULE D'AMORTISSEUR DE BRUIT AÉRIEN AÉRODYNAMIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **17.11.2017 US 201762587919 P
10.04.2018 US 201815949423**

(43) Date of publication of application:
**22.05.2019 Bulletin 2019/21**

(73) Proprietor: **Quanta Computer Inc.
Taoyuan City 33377 (TW)**

(72) Inventors:
• **CHEN, Chao-Jung
Taoyuan City 33377 (TW)**

• **HUANG, Yu-Nien
Taoyuan City 33377 (TW)**
• **TAN, Herman
Taoyuan City 33377 (TW)**
• **LIN, Chih-Wei
Taoyuan City 33377 (TW)**

(74) Representative: **Krauns, Christian
Wallinger Ricker Schlotter Tostmann
Patent- und Rechtsanwälte Partnerschaft mbB
Zweibrückenstraße 5-7
80331 München (DE)**

(56) References cited:
**CN-Y- 201 314 084     JP-A- 2014 016 411
US-A1- 2006 185 931     US-A1- 2011 063 795**

## Description

FIELD OF THE INVENTION

The present disclosure relates to an apparatus for suppressing noise emanating from individual electronic units within a server device.

BACKGROUND

The operation of a server system produces unnecessary heat. If the unnecessary heat produced during the operation of the server system is not removed, the efficiency of the server system will be compromised, and in turn the server system will be damaged. Typically, a fan is installed in the server system to dissipate heat and cool the server system.

With the increase in the operating speed of server systems, the heat produced during the operation of the server system is greatly increased. A high-speed fan is introduced to remove the unnecessary heat produced by the server system. However, noise made by the high-speed fan is louder than that of a typical fan. In light of these reasons, an optimization design for simultaneously noise reduction and heat dissipation of a computer system is imperative.

One method of enhancing heat dissipation efficiency is to increase or accelerate airflow through the server system. However, the stronger the airflow, the more turbulent and noisy wake flow may be. The wake is the region of disturbed flow (often turbulent) downstream of a solid body moving through a fluid, caused by the flow of the fluid around the body. Thus, a server system manufacturer faces a design challenge between noise and heat dissipation efficiency. The US 2006/185931 A1 discloses an acoustic noise reduction accessory apparatus attachable or made integral to a personal computer or other electronics equipment. The apparatus reduces acoustic noise emitted from the rear of the computer and it reduces the acoustic noise from circulating fans. The apparatus comprises an acoustic barrier or shielding member. The barrier is shaped in various forms externally of the computer or integrally extending from the back of the computer around one or more fans of the computer; the acoustic barrier member allows for minimum airflow reduction. Acoustic absorbing material is layered upon the acoustic barrier and it is combined with vibration absorbing material. The barrier is shaped from solid or flexible members to accommodate different sized electronics and formed to include baffles and structures to direct airflow while absorbing noise; and it is made adjustable by one or more slidable members. The US 2011/063795 A1 discloses a computer system including a chassis with a fan installed therein, a cover plate adapted to be attached to the chassis, and a noise absorber attached to the cover plate. The fan is used for generating an amount of air flow for cooling at least a component in the chassis. The noise absorber includes a plurality of protrusions facing the fan and used for of damping the air flow that impacts the cover plate and decreasing an acoustic noise level of the computer system. The CN 2013/14084 Y discloses a metallic panel absorber. The surface of a metallic sheet is provided with a plurality of large sound absorbing drop pits in a pressing mode; the large sound absorbing drop pits are communicated by drop channels; a plurality of small sound absorbing drop pits are arranged in gaps between the large sound absorbing drop pits; and the metallic sheet is also provided with a plurality of through micropores. Noise sound waves are repeatedly reflected and diffused by the large sound absorbing drop pits, the drop channels, the small sound absorbing drop pits and the through micropores. The JP 2014/016411 A discloses a sound absorbing material formed by laminating an unwoven fabric having a plurality of projections and a porous body, and including projections formed by the unwoven fabric comprising a plurality of fiber layers. The sound absorbing material includes a plurality of cavities formed by being surrounded by the fiber layers inside the projections.

SUMMARY

The problem of the present invention is solved by an aerodynamic noise absorber apparatus according to the independent claim 1 and a computing device according to claim 7. The dependent claims refer to advantageous further developments of the present invention. The following presents a simplified summary of one or more embodiments in order to provide a basic understanding of present technology. This summary is not an extensive overview of all contemplated embodiments of the present technology, and is intended to neither identify key or critical elements of all examples, nor delineate the scope of any or all aspects of the present technology. Its sole purpose is to present some concepts of one or more examples in a simplified form as a prelude to the more detailed description that is presented later.

Embodiments of the disclosure concern an apparatus for reducing noise resulting from a plurality of fans in a computing device. An apparatus is provided that includes a first distal end and a second distal end. The apparatus also includes a first connecting member located at the first distal end and a second connecting member located at the second distal end. The apparatus also includes at least one bracket secured within the apparatus at the first and second connecting members. The bracket includes a flow guiding depressions and micro pores. The apparatus also includes a plate configured to abut the bracket within the apparatus. The first and second connecting members are configured to connect the apparatus within a server device.

In some embodiments of the disclosure, the bracket can be made of sheet metal formed using at least one of bending, forming, and stamping. In alternative embodiments of the disclosure, the bracket can be made up of sound absorbing material. Furthermore, the apparatus can include two brackets secured within the apparatus at the first and second connecting members. In some embodiments of the disclosure, each of the flow guiding depressions can be a dome-shaped depression. In some embodiments of the disclosure, the micro pores can be located exclusively within the flow guiding depressions. In alternative embodiments of the disclosure, the micro pores can be located throughout the bracket to create a porous structure.

In some embodiments of the disclosure, the apparatus can also include sound absorbing material housed between the bracket and the plate. In some embodiments of the disclosure, each of the flow guiding depressions can be a conical-shaped depression.

Embodiments of the disclosure concern a computing device including the apparatus for reducing noise resulting from a plurality of fans. The computing device includes a row of drive bays configured to receive hard disk drives. Each of the hard disk drives can be separated by a gap.

The computing device includes also fan modules positioned opposite of the plurality of hard disk drives within the computing device. In some embodiments of the disclosure, the apparatus can be located within a critical distance from the fan modules such that a sound wave length is prevented from forming before contacting any surface within the flow guiding depressions. In some embodiments of the disclosure, each of the flow guiding depressions can be positioned at the gap between the hard disk drives.

BRIEF DESCRIPTION OF THE DRAWINGS

FIG. 1 is a top isometric view of a server device that includes hard disk drive airflow according to an embodiment;

FIG. 2 shows a simplified block diagram of an aerodynamic noise absorber apparatus in the system according to an embodiment;

FIG. 3 shows a top isometric view of a server device that includes a plurality of aerodynamic noise absorber apparatuses according to an embodiment;

FIG. 4A shows a front isometric view of the apparatus for enhancing the hard disk drive performance by resolving the issue between noise, heat dissipation efficiency and HDD read/ write performance according to an embodiment;

FIG. 4B shows a rear isometric view of the apparatus for enhancing the hard disk drive performance by resolving the issue between noise, heat dissipation efficiency and HDD read/ write performance according to an embodiment;

FIG. 5 shows a top view of a server device incorporating the apparatus of FIGS. 4A and 4B according to an embodiment;

FIG. 6 shows a top view of the apparatus within the server device exemplifying reflected noise according to an embodiment;

FIG. 7 shows side view of the apparatus within the server device exemplifying the reflected noise according to an embodiment;

FIG. 8A shows a top view of the apparatus receiving direct airflow from a fan according to an embodiment;

FIG. 8B shows a side view of the apparatus receiving direct airflow from the fan according to an embodiment; and

FIG. 9 is a top view of the apparatus in the server device according to an embodiment.

DETAILED DESCRIPTION

The present invention is described with reference to the attached figures, wherein like reference numerals are used throughout the figures to designate similar or equivalent elements. The figures are not drawn to scale, and they are provided merely to illustrate the instant invention. Several aspects of the invention are described below with reference to example applications for illustration. It should be understood that numerous specific details, relationships, and methods are set forth to provide a full understanding of the invention. One having ordinary skill in the relevant art, however, will readily recognize that the invention can be practiced without one or more of the specific details or with other methods. In other instances, well-known structures or operations are not shown in detail to avoid obscuring the invention. The present invention is not limited by the illustrated ordering of acts or events, as some acts may occur in different orders and/or concurrently with other acts or events. Furthermore, not all illustrated acts or events are required to implement a methodology in accordance with the present invention.

As previously explained, it is common to introduce increased or accelerated airflow through a server system to remove the overwhelming heat produced by the components within the server system. However, stronger airflows can be more turbulent and introduce a significant amount of noise or vibration. This increased vibration and noise can cause reduced HDD read/write performance. In order to balance noise, heat dissipation efficiency, and HDD read/write performance, embodiments of the present invention provide an aerodynamic noise absorber apparatus (hereinafter referred to as "apparatus") for hard disk drive airflow. In this disclosure, the apparatus serves as an aerodynamic device with sound absorbing flow guiding depressions to enhance hard disk drive performance by resolving the issue between noise, heat dissipation efficiency, and HDD read/write performance. Specifically, the flow guiding depressions are configured to not disrupt the airflow while providing a sound barrier of the plurality of fan modules to the storage array module. The apparatus is positioned at a critical distance from the plurality of fan modules to maximize noise wave absorption.

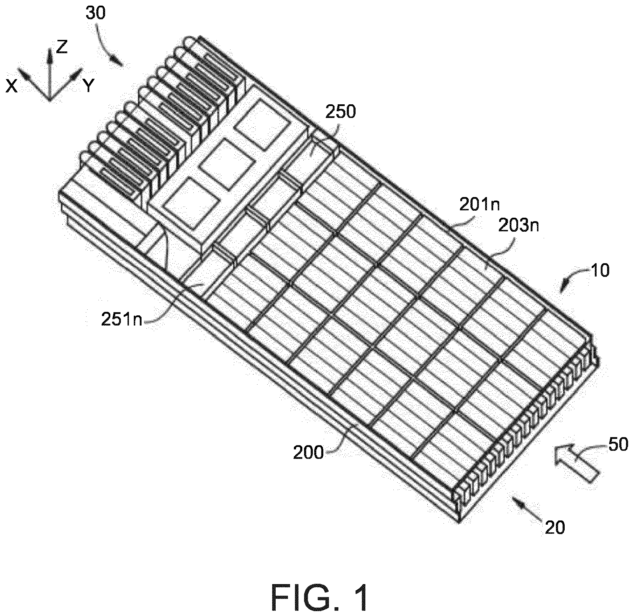

FIG. 1 is a top isometric view of a server device 10 exemplifying airflow 50 according to an embodiment. In some embodiments, the server device 10 includes a plurality of fan modules 250 and a storage array module 200. The server device 10 can include a front end 20 and a rear end 30. The airflow 50 can come across the server device 10 and the encompassed storage array module 200, from the front end 20 to the rear end 30, via the plurality of fan modules 250. It should be understood that the server device 10 includes other components not mentioned herein. The components mentioned above are only for example, and not to limit this disclosure. The person having ordinary knowledge in the art may flexibly include other components in accordance to the invention.

In some embodiments, the storage array module 200 is disposed in the server device 10. To maximize storage, the storage array module 200 can include a plurality of storage arrays 201n closely stacked together. The space 202 between the plurality of storage arrays 201n is very small, to maximize the number of storage arrays 201n. In Figure 1, the storage array module 200 can include eighteen storage arrays closely stacked together. Each of the storage arrays contains a plurality of disk devices 203n. The plurality of disk devices 203n can include hard disk drive, solid state disk drives, or a combination thereof. Furthermore, for the purpose of this invention, the plurality of disk devices 203n can include other drive technology not detailed herein. In Figure 1, the plurality of disk devices can include ninety hard disk drives. It should be realized that the quantities of the storage arrays (e.g., eighteen) and disk devices (e.g., ninety) mentioned above are only for example, and not to limit this disclosure. The person having ordinary knowledge in the art may flexibly select any proper quantity of storage arrays according to the requirement.

The plurality of fan modules 250 in the server device 10 is arranged in parallel. In an embodiment of the invention, the plurality of fan modules 250 is disposed near the storage array module 200 to cool the storage array module 200 via convection. The plurality of fan modules 250 is utilized to enhance the air convection across the server device 10 from the front end 20 to the rear end 30. The plurality of fan modules 250 can include four high-powered computer device fans (hereinafter referred to as "fan") 251n. Thus, the airflow 50 generated by each fan 25 In flows into and out of the server device 10 along an x-axis though the plurality of storage arrays 201n closely stacked together. Wake flow is generated by the blades of each of the plurality of fan modules 250 blowing on interior surfaces and other components of the server device 10. A blasting point is generated and regarded as a sound source that generates a band noise.

Consequently, for efficiency, the airflow 50 flowing along the x-axis in the present embodiment is increased by increasing the rotational speeds of each of the plurality of fan modules 250. Airflow 50 is increased to effectively cool between the nominal spaces between the plurality of storage arrays 201n. This enables the plurality of fan modules 250 to maintain the storage array module 200 at the desired operating temperature. However, the more the rotational speed and the flow rate are increased, the higher the frequency of the noise band. Furthermore, each of the plurality of fan modules 250 is loud when operating. The noise comes from not only the fan itself, but also the quantity of the magnetic poles, revolutions, blades of the fan, and combinations thereof. Therefore, the desire to cool the storage array module 200 with increased airflow 50 leads to an increase in noise. It should be understood that the quantity of the fans (e.g., four) mentioned above is only for example, and not to limit this disclosure. The person having ordinary knowledge in the art may flexibly select any proper quantity of fans in accordance with the disclosure.

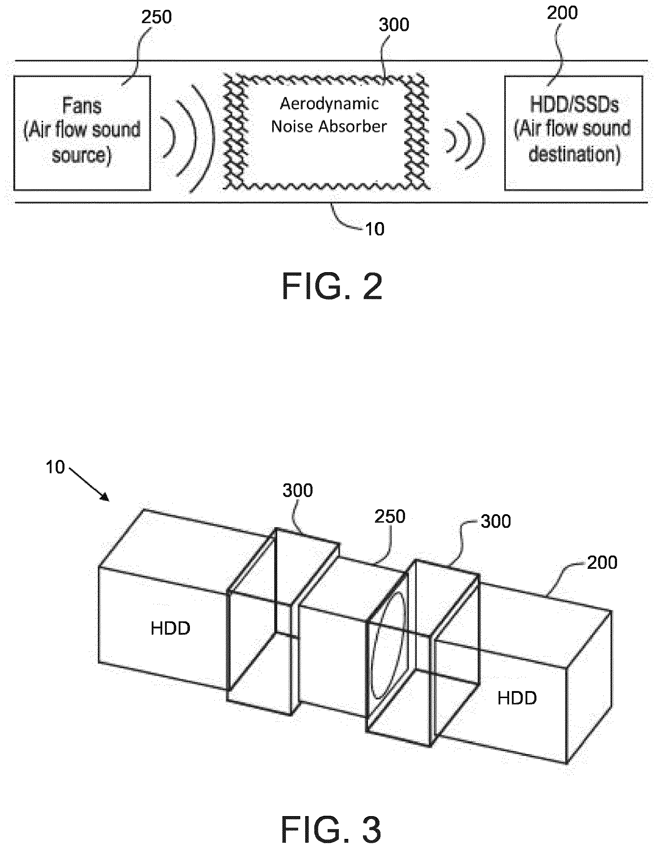

FIG. 2 shows a simplified block diagram of an aerodynamic noise absorber apparatus (hereinafter referred to as "apparatus") 300 in the server device 10 (in FIG. 1). The apparatus 300 provides a material that enables air flow so as to not disrupt the airflow 50 (in FIG. 1) while providing a sound barrier to the plurality of fan modules 250 of the storage array module 200. As indicated above, a high-speed fan is introduced to remove the unnecessary heat produced by the server device 10. However, noise made by the high-speed fan is louder than the sound produced by a typical fan. As a result, the high-speed fan will generate high sound pressure level (SPL) and cause the HDD performance of reading/writing data to perform poorly. In light of these reasons, the optimization design for noise reducing and heat dissipating of the computer system is imperative. As explained below, the apparatus 300 provides sound reflection, diffraction and absorption to mitigate the noise of the plurality of fan modules 250.

FIG. 3 is a top isometric view of a server device 10 that employs multiple apparatuses 300. In some embodiments, the server device 10 can orient the plurality of fan modules 250 between the storage array modules 200 to improve airflow 50 (in FIG.1) exhaust from the server device 10. In this case, the server device 10 can employ multiple apparatuses 300 to protect storage array modules 200 oriented on either side of the plurality of fan modules 250. Furthermore, the apparatus 300 can be positioned or relocated with respect to the critical distance, defined below, within the server device 10 to maximize performance of the storage array modules 200 and improve airflow 50 exhaust from the server device 10.

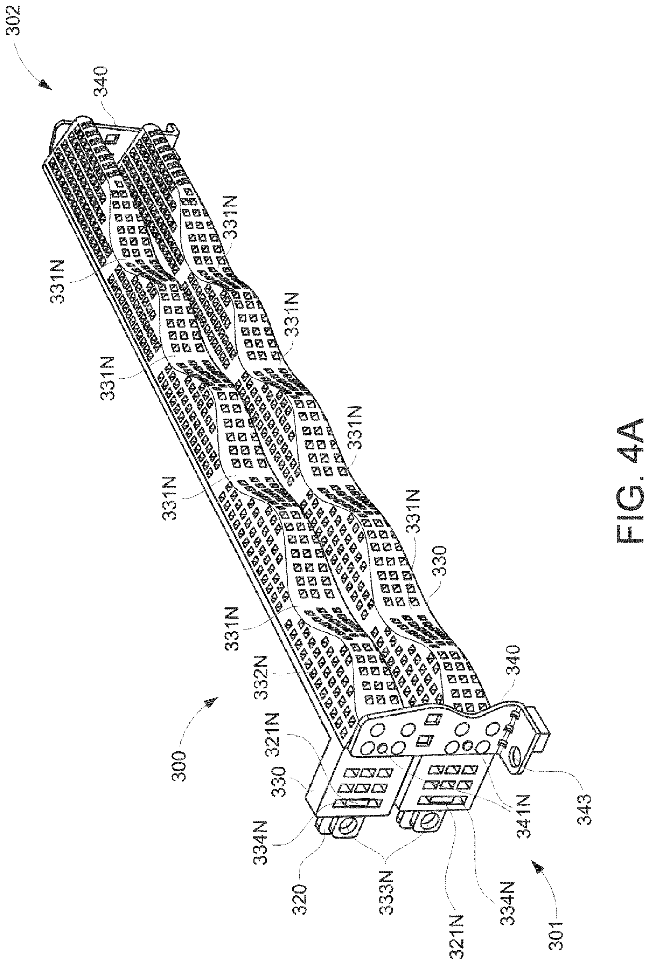

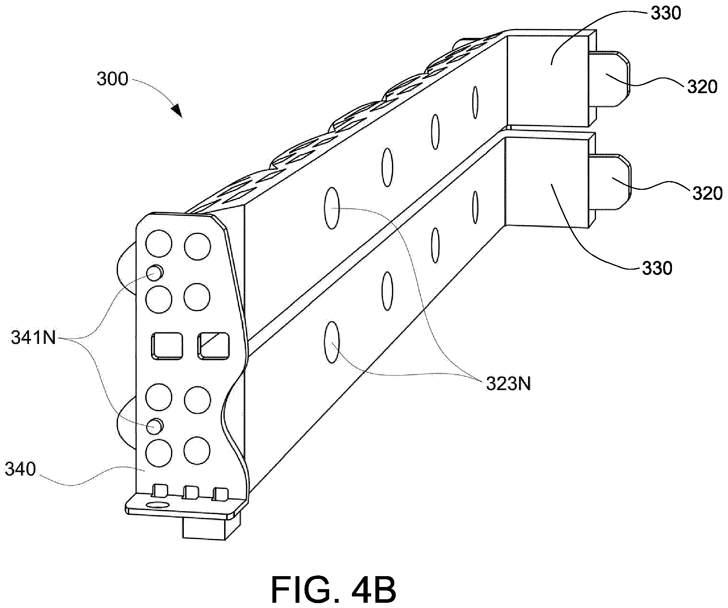

FIG. 4A is a front isometric view of the apparatus 300 for enhancing the hard disk drive performance by resolving the issue between noise, heat dissipation efficiency and HDD read/write performance. FIG. 4B is a rear isometric view of the apparatus 300. The apparatus 300 a first distal end 301 and opposing second distal end 302. The apparatus 300 also includes a bracket 330, a plate 320 abutting the bracket 330, and a connecting member 340 configured to secure the apparatus 300 within an exemplary server device. As shown herein, the apparatus 300 can include multiple brackets 330, with corresponding multiple plates 320, and connecting member 340 connecting the multiple brackets 330. The plate 320 is shown clearly with respect to FIG. 4B.

The plate 320 includes tabs 321N at the first distal end 301. The bracket 330 has an opening 334N at the first distal end 301. The opening 334N corresponds with the tabs 321N. The plate 320 is configured to connect to the bracket 330 via the tabs 321N. The tabs 321N allows the plate 320 to snap into place on the bracket 330. The plate 320 also includes guide holes 323N. The plate 320 is fixed to the bracket 330 by incorporating screws, weld points, or other securing methods at the guide holes 323N.

The bracket 330 includes flow guiding depressions 331N. In some embodiments, the flow guiding depressions 331N is dome-shaped. In alternative embodiments, the flow guiding depressions 331N is conical-shaped. In some embodiments, the bracket 330 includes micro pores 332N on all of its surfaces. In some embodiments, the micro pores 332N are located exclusively within the flow guiding depressions 331N. The bracket 330 also includes connecting members 333N. The connecting members 333N are configured to secure the apparatus 300 to other electronic components within a server device.

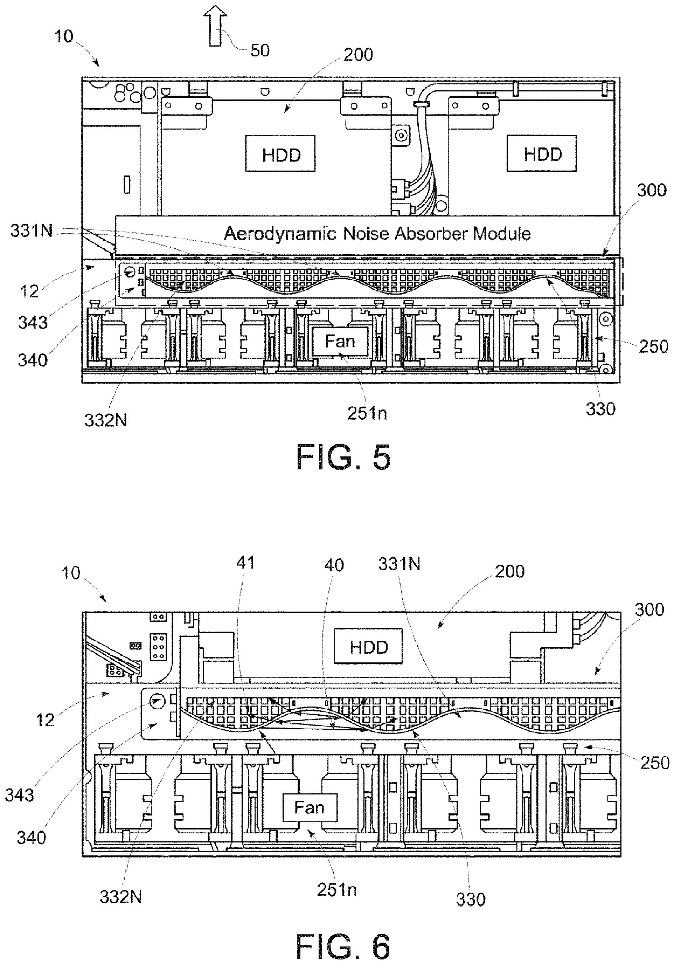

The apparatus 300 can also include at the first and second distal ends 301 and 302 connecting member 340 at the first and second distal ends 301 and 302. The connecting member 340 can be configured to secure multiple brackets 330 within the apparatus 300. Furthermore, the connecting member 340 can secure the apparatus 300 within a server device (not shown). The connecting member 340 can include openings 341N. The openings 341N can be configured to receive a securing element, such as a screw, to secure the connecting member 340 to the brackets 330. The connecting member 340 can also include apertures 343. The apertures 343 can be configured to secure the apparatus 300 to a base within the server device. Securing the apparatus 300 within a server device is shown in more detail with respect to FIG. 5 below.

The bracket 330 and its components can be made of sheet metal using conventional metal fabrication techniques, such as bending, forming, and stamping. As a result, the bracket 330 can be made very inexpensively. In alternative embodiments, the bracket 330 and its components can be made aluminum alloy, steel alloy, or any combination thereof. It should be understood that the bracket 330 and its components can be made of any material constructed to withstand varying temperatures, and air flow of high velocity from high-powered fans.

In some embodiments, the bracket 330 can house sound absorbing material between the bracket 330 and the plate 320. Alternatively, the bracket 330 can be made from sound absorbing material. The sound absorbing material can include glass, wool, urethane foam, and similar materials. Such materials are applicable as all or part of the materials of the plurality of flow guiding depressions 331N and plurality of micro pores 332N. It should be realized that the sound absorber material can be any material constructed to perform with high efficiency in regards to noise reduction. The materials mentioned above are only for example, and not to limit this disclosure.

The person having ordinary knowledge in the art may flexibly select any material in accordance with the disclosure.

FIG. 5 is a top view of a server device 10 incorporating the apparatus 300 of FIGS. 4A and 4B. The server device 10 can have a base 12. The server device 10 can also include a plurality of fan modules 250 and a storage array module 200. The apparatus 300 can be positioned between the plurality of fan modules 250 and the storage array module 200. The apparatus 300 can be secured within the server device 10 by the connecting member 340. Specifically, the apparatus 300 can be secured to the base 12 via the aperture 343. In some embodiments, the apparatus 300 can include a number of flow guiding depressions 331N. Furthermore, the plurality of fan modules 250 can include an individual fan 251n.

The flow guiding depressions 331N can be located directly in front of a corresponding fan 251n. In this orientation, airflow 50 can be prevented from being undesirably directed or lost between each of the flow guiding depressions 331N. As a result, the flow guiding depressions 331N are position closely together in alignment with the fan 25 In. Each micro pore 332N can be spatially scattered within the bracket 330 to create a highly porous material to allow for air flow 50 through the server device 10. The resulting configuration reflects noise generated by the plurality of fan modules 250 while enabling air flow 50 through the server device 10.

FIG. 6 is a top view of the apparatus 300 within the server device 10 exemplifying reflected noise. As indicated above, noise made by a high-powered computer device fan 251n generates higher noise than a typical fan. Each fan 25 In has a blade pass frequency (BPF) within a different range than the hard drive natural frequency of the disk device 203N (shown in FIG. 1) of the storage array modules 200. In some embodiments, the hard drive natural frequency can range from 1200-2500 (Hz). The fan blade pass frequency is highly related to the number of blades of the fan and its rotation per minute during in-system operation. In some embodiments, the noise generated from the plurality of fan modules 250 can be reflected within the flow guiding depressions 331N. In alternative embodiments, the reflected noise 40 can be captured within the bracket 330.

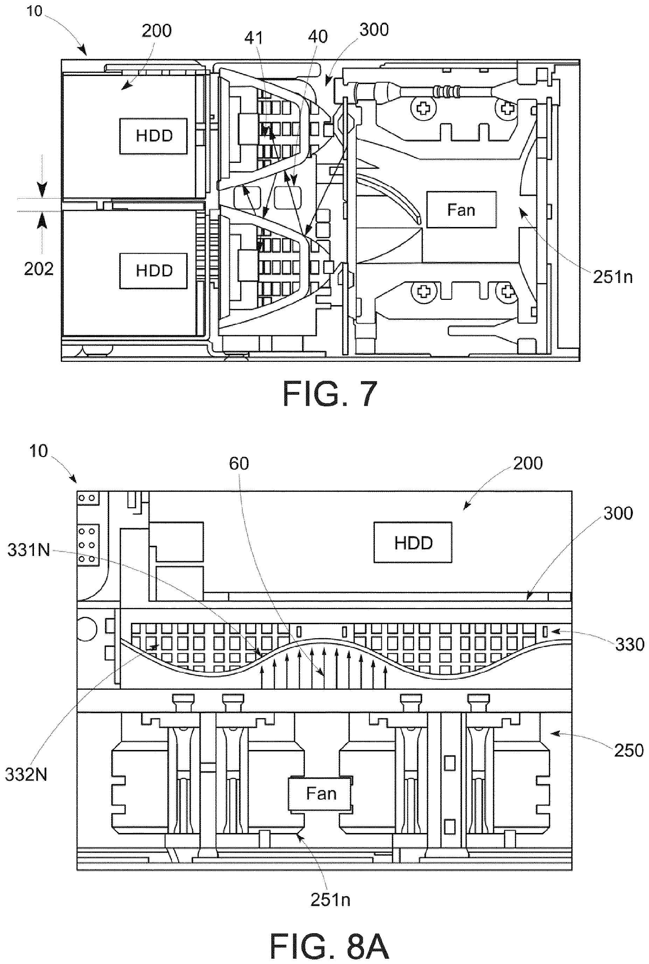

FIG. 7 is a side view of the apparatus 300 within the server device 10 exemplifying the reflected noise. The flow guiding depressions 331N can be configured to dampen the reflected noise 40 waves to create absorbed noise 41 waves. The majority of the reflected noise 40 waves are absorbed within the flow guiding depressions 331N of the bracket 330. As indicated in FIG. 6 little to none of the absorbed noise 41 is allowed to pass through the space 202 between the plurality of storage arrays 201N. Therefore, the presence of the flow guiding depressions 331N can increase the absorbing efficiency of the apparatus 300. Furthermore, the absence of the absorbed waves 41 and the reflected noise 40 in the space 202 maximizes the performance of the HDD reading/writing performance.

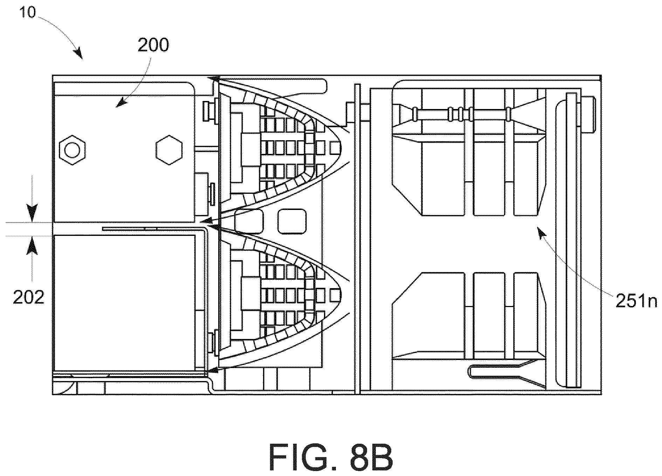

FIG. 8A illustrates a top view of the apparatus 300 receiving direct airflow 60 from the fan 25 In. FIG. 8B illustrates a side view of the apparatus 300 receiving direct airflow 60 from the fan 251n. Each of the flow guiding depressions 331N can receive airflow 60 from a corresponding fan 251n. As indicated above, the apparatus 300 includes micro pores 332N. The flow guiding depressions 331N and the micro pores 322N can be configured to allow lower pressure and greater airflow. As discussed above with respect to FIGS. 5 and 6, the flow guiding depressions 331N can minimize the pressure. Furthermore, the micro pores 332N can be configured to trap sound waves resulting from operation of the fan 251n and the airflow 60. The micro pores 332N can also enable an aerodynamic design to ensure the apparatus 300 does not block the airflow 60.

As indicated in FIG. 8B, the airflow 60 is guided along the surface of the flow guiding depressions 331N. As a result of each of the flow guiding depressions 331N positioned in front of each fan 251n, airflow 60 is prevented from being directed or lost between each of the guiding depressions 331N. Furthermore, the flow guiding depressions 331N can be positioned between each of the storage arrays 201N in the space 202. In this embodiment, airflow 60 is prevented from flowing in the space 202 between the storage arrays 201N. In some embodiments, the apparatus 300 is positioned at a calculated distance from the plurality of fan modules 250.

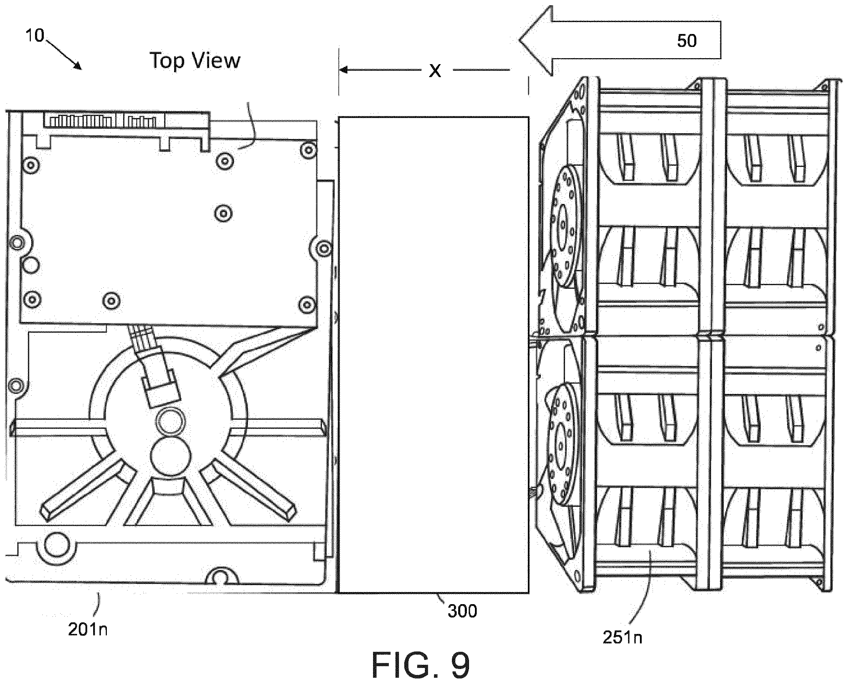

FIG. 9 is a top view of the apparatus 300 in the server device 10 exemplifying a critical distance according to an embodiment of the disclosure. In some embodiments, the placement of the apparatus 300 in the server device 10 directly affects the sound wave length emanating from the plurality of fan modules 250. In some embodiments, a critical distance can be defined as the distance between the apparatus 300 and the plurality of fan modules 250. Specifically, the critical distance can be defined as the maximum distance where the maximum amplitude of the noise wave occurs. In some embodiments, the critical distance can be defined as:

$$x = \frac{5.4 \times 10^6}{n \times v}$$

In the formula above, x represents the distance in millimeters between the apparatus 300 and the plurality of fan modules 250. Moreover, the n represents the number of fan blades incorporated in each fan 251n. As indicated above, the fan blade pass frequency is highly related to the number of fan blades of the fan and its rotation per minute during operation. Value v represents the fan speed in rotations per minute. In some embodiments, 360 meters per second is a normalized sound speed. Furthermore, a typical high-powered computer device fan 251n can rotate at 21600 rotations per minute with five fan blades. As a result, the critical distance between the apparatus 300 and the plurality of fan modules 250 should not exceed 50 millimeters. When the apparatus 300 is placed within the critical distance the noise wave absorption is maximized such that it will not interfere with the natural frequency of the storage array 201N which can cause performance degradation.

While various embodiments of the present invention have been described above, it should be understood that they have been presented by way of example only, and not limitation. Rather, the scope of the invention should be defined in accordance with the appended claims.

The terminology used herein is for the purpose of describing particular embodiments only and is not intended to limit the invention. As used herein, the singular forms "a," "an," and "the" are intended to include the plural forms as well, unless the context clearly indicates otherwise. Furthermore, to the extent that the terms "including," "includes," "having," "has," "with," or variants thereof are used in either the detailed description and/or the claims, such terms are intended to be inclusive in a manner similar to the term "comprising."

Unless otherwise defined, all terms (including technical and scientific terms) used herein have the same meaning as commonly understood by one of ordinary skill in the art to which this invention.

## Claims

1. An aerodynamic noise absorber apparatus (300) configured to be connected within a server device (10) between a plurality of hard disk drives (HDD) and a plurality of fan modules (250), the aerodynamic noise absorber apparatus (300) comprising:

   a first distal end (301) and a second distal end (302);
   a first connecting member (340) located at the first distal end (301);
   a second connecting member (340) located at the second distal end (302);

one or more brackets (330) secured each at the first and second connecting members (340), wherein each of the one or more brackets (330) extends between the first and the second connecting members (340) and comprises a flat base, a plurality of airflow guiding depressions (331N) on a side opposite the flat base, and a plurality of micro pores (332N) to allow for air flow (50) through the server device (10); and one or more plates (320) abutting each against a corresponding one of the one or more brackets (330);

wherein the first and second connecting members (340) are configured to connect the aerodynamic noise absorber apparatus (300) within the server device (10) between the plurality of hard disk drives (HDD) and the plurality of fan modules (250) with said one or more plates (320) facing the plurality of hard disk drives (203n) and the plurality of airflow guiding depressions (331N) facing the plurality of fan modules (250), in order to reduce noise from the plurality of fan modules (250) while enabling air flow (50) through the server device (10).

2. The aerodynamic noise absorber apparatus (300) of claim 1, wherein the one or more brackets (330) comprise each sheet metal formed using at least one of bending, forming, and stamping, or sound absorbing material.

3. The aerodynamic noise absorber apparatus (300) of claim 1 or 2, comprising two brackets secured at the first and second connecting members (340).

4. The aerodynamic noise absorber apparatus (300) of anyone of the claims 1 to 3, wherein each of the plurality of airflow guiding depressions (331N) comprises a dome-shaped depression, or each of the plurality of airflow guiding depressions (331N) comprises a conical-shaped depression.

5. The aerodynamic noise absorber apparatus (300) of anyone of the claims 1 to 4, wherein the plurality of micro pores (332N) are located separately within the airflow guiding depressions (331N), and the plurality of micro pores (332N) are located throughout the one or more brackets to create a porous structure.

6. The aerodynamic noise absorber apparatus (300) of anyone of the claims 1 to 5, further comprising sound absorbing material housed between each of the one or more brackets (330) and the corresponding plates (330) of the one or more plates (320).

7. A computing device comprising:

at least one row (201n) of drive bays configured to receive a plurality of hard disk drives (203n), each of the hard disk drives separated by a gap; a plurality of fan modules (250) positioned within the computing device opposite of the at least one row of drive bays for the plurality of hard disk drives; and an aerodynamic noise absorber apparatus (300) according to any one of the claims 1 to 6, wherein the aerodynamic noise absorber apparatus (300) is disposed between the at least one row of drive bays for the plurality of hard disk drives (203n) and a plurality of fan modules (250), with said at least one plate (320) of the aerodynamic noise absorber facing the at least one row of drive bays for the plurality of hard disk drive and the plurality of airflow guiding depressions (331N) of the aerodynamic noise absorber facing the plurality of fan modules (250), in order to to reduce noise from the plurality of fan modules (250).

8. The computing device of claim 7, wherein the aerodynamic noise absorber apparatus (300) is located within a critical distance from the plurality of fan modules (250) which corresponds to a distance where a maximum amplitude of a noise wave from the plurality of fan modules (250) occurs.

**Patentansprüche**

1. Aerodynamische Vorrichtung (300) zur Schallabsorption, die ausgestaltet ist, um mit einer Servervorrichtung (10) zwischen einer Vielzahl an Festplattenlaufwerken (HDD) und einer Vielzahl an Lüftermodulen (250) verbunden zu werden, wobei die aerodynamische Vorrichtung (300) zur Schallabsorption aufweist:

ein erstes distales Ende (301) und ein zweites distales Ende (302), ein erstes Verbindungselement (340), das an dem ersten distalen Ende (301) angeordnet ist, ein zweites Verbindungselement (340), das an dem zweiten distalen Ende (302) angeordnet ist, eine oder mehrere Halterungen (330), die jeweils an dem ersten und dem zweiten Verbindungselement (340) befestigt sind, wobei sich jede der einen oder mehreren Halterungen (330) zwischen dem ersten und dem zweiten Verbindungselement (340) erstreckt und eine flache Basis, eine Vielzahl an Luftstromführungsvertiefungen (331N) auf einer Seite gegenüber der flachen Basis und eine Vielzahl an Mikroporen (332N) aufweist, um einen Luftstrom (50) durch die Servervorrichtung (10) zu ermöglichen, und eine oder mehrere Platten (320), die jeweils an einer entsprechenden der einen oder mehreren Halterungen (330) anliegen, um einen Luftstrom (50) durch die Servervorrichtung (10) zu ermöglichen,

wobei das erste und das zweite Verbindungselement (340) ausgestaltet sind, um die aerodynamische Vorrichtung (300) zur Schallabsorption innerhalb der Servervorrichtung (10) zwischen der Vielzahl der Festplattenlaufwerke (HDD) und der Vielzahl der Lüftermodule (250) mit der einen oder den mehreren Platten (320), die der Vielzahl der Festplattenlaufwerken (203n) zugewandt sind, und der Vielzahl der Luftstromführungsvertiefungen (331N) zu verbinden, die der Vielzahl der Lüftermodulen (250) zugewandt sind, um Geräusche von der Vielzahl der Lüftermodulen (250) zu verringern, während der Luftstrom (50) durch die Servervorrichtung (10) ermöglicht wird.

2. Aerodynamische Vorrichtung (300) zur Schallabsorption nach Anspruch 1, wobei die eine oder die mehreren Halterungen (330) jeweils ein Blech, das mittels eines Biegens, eines Formens und / oder eines Stanzens gebildet worden ist, oder ein Schall absorbierendes Material aufweisen.

3. Aerodynamische Vorrichtung (300) zur Schallabsorption nach Anspruch 1 oder 2, die zwei Halterungen aufweist, die an dem ersten und dem zweiten Verbindungselement (340) befestigt worden sind.

4. Aerodynamische Vorrichtung (300) zur Schallabsorption nach einem der Ansprüche 1 bis 3, wobei jede von der Vielzahl der Luftstromführungsvertiefungen (331N) eine kuppelförmige Vertiefung oder jede von der Vielzahl der Luftstromführungsvertiefungen (331N) eine konisch geformte Vertiefung aufweist.

5. Aerodynamische Vorrichtung (300) zur Schallabsorption nach einem der Ansprüche 1 bis 4, wobei die Vielzahl der Mikroporen (332N) separat in den Luftstromführungsvertiefungen (331N) angeordnet sind und die Vielzahl der Mikroporen (332N) in der einen oder den mehreren Halterungen angeordnet sind, um eine poröse Struktur zu erzeugen.

6. Aerodynamische Vorrichtung (300) zur Schallabsorption nach einem der Ansprüche 1 bis 5, die ferner ein Schall absorbierendes Material aufweist, das zwischen jeder der einen oder der mehreren Halterungen (330) und den entsprechenden Platten (330) der einen oder der mehreren Platten (320) angeordnet ist.

7. Computervorrichtung, welche aufweist:

mindestens eine Reihe (201n) an Laufwerksschächten, die ausgestaltet sind, um mehrere Festplattenlaufwerke (203n) aufzunehmen, wobei jedes der Festplattenlaufwerke durch einen Spalt getrennt ist,

eine Vielzahl an Lüftermodulen (250), die in der Computervorrichtung gegenüber der mindestens einen Reihe von Laufwerkschächten für die Vielzahl der Festplattenlaufwerken angeordnet sind, und

eine aerodynamische Vorrichtung (300) zur Schallabsorption nach einem der Ansprüche 1 bis 6,

wobei die aerodynamische Vorrichtung (300) zur Schallabsorption zwischen der mindestens einen Reihe von Laufwerksschächten für die Vielzahl der Festplattenlaufwerke (203n) und der Vielzahl der Lüftermodulen (250) angeordnet ist, wobei die mindestens eine Platte (320) der aerodynamische Schallabsorption der mindestens einen Reihe von Laufwerksschächten für die Vielzahl der Festplattenlaufwerke und die Vielzahl der Luftstromführungsvertiefungen (331N) der aerodynamische Schallabsorption der Vielzahl der Lüftermodule (250) zugewandt ist, um Geräusche von der Vielzahl der Lüftermodulen (250) zu verringern, während der Luftstrom (50) durch die Servervorrichtung (10) ermöglicht wird.

8. Computervorrichtung nach Anspruch 7, wobei die aerodynamische Vorrichtung (300) zur Schallabsorption in einem kritischen Abstand von der Vielzahl der Lüftermodule (250) angeordnet ist, der einem Abstand entspricht, in dem eine maximale Amplitude einer Schallwelle von der Vielzahl der Lüftermodulen (250) auftritt.

**Revendications**

1. Appareil amortisseur de bruit aérien aérodynamique (300) configuré pour être relié à l'intérieur d'un dispositif serveur (10) entre une pluralité d'unités de disque dur (HDD) et une pluralité de modules de ventilateur (250), l'appareil amortisseur de bruit aérien aérodynamique (300) comprenant :

une première extrémité distale (301) et une seconde extrémité distale (302) ;
un premier élément de liaison (340) situé à la première extrémité distale (301) ;
un second élément de liaison (340) situé à la seconde extrémité distale (302) ;
un ou plusieurs supports (330) fixés chacun au niveau des premier et second éléments de liaison (340), dans lequel chacun desdits un ou plusieurs supports (330) s'étend entre les premier et second éléments de liaison (340) et comprend une base plate, une pluralité de dépressions de guidage d'écoulement d'air (331N) sur un côté opposé à la base plate, et une pluralité de micropores (332N) pour permettre un écoulement d'air (50) à travers le dispositif serveur (10) ; et

une ou plusieurs plaques (320) chacune en butée contre un support correspondant desdits un ou plusieurs supports (330) ;

dans lequel les premier et second éléments de liaison (340) sont configurés pour relier l'appareil amortisseur de bruit aérien aérodynamique (300) à l'intérieur du dispositif serveur (10) entre la pluralité d'unités de disque dur (HDD) et la pluralité de modules de ventilateur (250) avec lesdites une ou plusieurs plaques (320) faisant face à la pluralité d'unités de disque dur (203n) et la pluralité de dépressions de guidage d'écoulement d'air (331N) faisant face à la pluralité de modules de ventilateur (250), afin de réduire le bruit issu de la pluralité de modules de ventilateur (250) tout en permettant à l'air de s'écouler (50) à travers le dispositif serveur (10).

2. Appareil amortisseur de bruit aérien aérodynamique (300) selon la revendication 1, dans lequel lesdits un ou plusieurs supports (330) comprennent chacun une tôle formée à l'aide d'au moins l'un parmi un pliage, une mise en forme et un estampage, ou un matériau d'amortissement acoustique.

3. Appareil amortisseur de bruit aérien aérodynamique (300) selon la revendication 1 ou 2, comprenant deux supports fixés au niveau des premier et second éléments de liaison (340).

4. Appareil amortisseur de bruit aérien aérodynamique (300) selon l'une quelconque des revendications 1 à 3, dans lequel chacune de la pluralité de dépressions de guidage d'écoulement d'air (331N) comprend une dépression en forme de dôme, ou chacune de la pluralité de dépressions de guidage d'écoulement d'air (331N) comprend une dépression en forme de cône.

5. Appareil amortisseur de bruit aérien aérodynamique (300) selon l'une quelconque des revendications 1 à 4, dans lequel la pluralité de micropores (332N) sont situés séparément à l'intérieur des dépressions de guidage d'écoulement d'air (331N), et la pluralité de micropores (332N) sont situés sur la totalité desdits un ou plusieurs supports pour créer une structure poreuse.

6. Appareil amortisseur de bruit aérien aérodynamique (300) selon l'une quelconque des revendications 1 à 5, comprenant en outre un matériau d'amortissement acoustique logé entre chacun desdits un ou plusieurs supports (330) et les plaques correspondantes (330) desdites une ou plusieurs plaques (320).

7. Dispositif informatique comprenant :

au moins une rangée (201n) de baies d'unité configurées pour recevoir une pluralité d'unités de disque dur (203n), chacune des unités de disque dur étant séparée par un espace ;
une pluralité de modules de ventilateur (250) positionnés à l'intérieur du dispositif informatique à l'opposé de l'au moins une rangée de baies d'unité pour la pluralité d'unités de disque dur ; et
un appareil amortisseur de bruit aérien aérodynamique (300) selon l'une quelconque des revendications 1 à 6,
dans lequel l'appareil amortisseur de bruit aérien aérodynamique (300) est disposé entre l'au moins une rangée de baies d'unité pour la pluralité d'unités de disque dur (203n) et une pluralité de modules de ventilateur (250), avec ladite au moins une plaque (320) de l'amortisseur de bruit aérien aérodynamique faisant face à l'au moins une rangée de baies d'unité pour la pluralité d'unités de disque dur et la pluralité de dépressions de guidage d'écoulement d'air (331N) de l'absorbeur de bruit aérien aérodynamique faisant face à la pluralité de modules de ventilateur (250), afin de réduire le bruit issu de la pluralité de modules de ventilateur (250).

8. Dispositif informatique selon la revendication 7, dans lequel l'appareil amortisseur de bruit aérien aérodynamique (300) est situé dans une distance critique à la pluralité de modules de ventilateur (250) qui correspond à une distance où une amplitude maximale d'une onde de bruit issue de la pluralité de modules de ventilateur (250) se manifeste.

FIG. 1

FIG. 2

FIG. 3

FIG. 4A

FIG. 4B

EP 3 486 744 B1

10

50

200

HDD    HDD

300

331N

Aerodynamic Noise Absorber Module

12

343

340

Fan

250

332N

251n

330

# FIG. 5

10    41    40    331N    200

HDD

300

12

343

340

Fan

250

332N

251n

330

# FIG. 6

FIG. 7

FIG. 8A

FIG. 8B

FIG. 9

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006185931 A1
- US 2011063795 A1
- CN 201314084 Y
- JP 2014016411 A